# EUROPEAN PATENT SPECIFICATION

(11) **EP 3 700 228 B1**
(45) Date of publication and mention of the grant of the patent: **30.03.2022**
(21) Application number: 20157066.0
(22) Date of filing: 13.02.2020
(51) Int. Cl.: H04R 17/00, H04R 19/04, H04R 17/02

(54) **MANUFACTURING METHOD OF A PIEZOELECTRIC MICROPHONE WITH PILLAR STRUCTURE**
VERFAHREN ZUR HERSTELLUNG EINES PIEZOELEKTRISCHEN MIKROFONS MIT SÄULENSTRUKTUR
PROCÉDÉ DE FABRICATION D'UN MICROPHONE PIÉZOÉLECTRIQUE À STRUCTURE EN PILIER

(30) Priority: 20.02.2019 IT 201900002481
(43) Date of publication of application: 26.08.2020
(73) Proprietor: Ask Industries Societa' per Azioni, 60037 Monte San Vito (AN) (IT)
(72) Inventor: LUGLI, Paolo, 39100 Bolzano (IT); LARCHER, Luca, 42123 Reggio Emilia (IT); RICCI, Yuri, 42122 Reggio Emilia (IT); CATTANI, Luca, 42019 Scandiano (RE) (IT); NILI, TIZIANO, 44123 Reggio Emilia (RE) (IT)
(74) Representative: Cutropia, Gianluigi

(56) References cited:
- WO-A1-01/67810
- KR-B1- 101 133 141
- KR-B1- 101 758 017
- US-A1- 2015 256 913
- US-A1- 2016 179 276
- XU J ET AL: "Microphone based on Polyvinylidene Fluoride (PVDF) micro-pillars and patterned electrodes", SENSORS AND ACTUATORS A: PHYSICAL, ELSEVIER BV, NL, vol. 153, no. 1, 25 June 2009 (2009-06-25) , pages 24-32, XP026157977, ISSN: 0924-4247, DOI: 10.1016/J.SNA.2009.04.008 [retrieved on 2009-04-24]

## Description

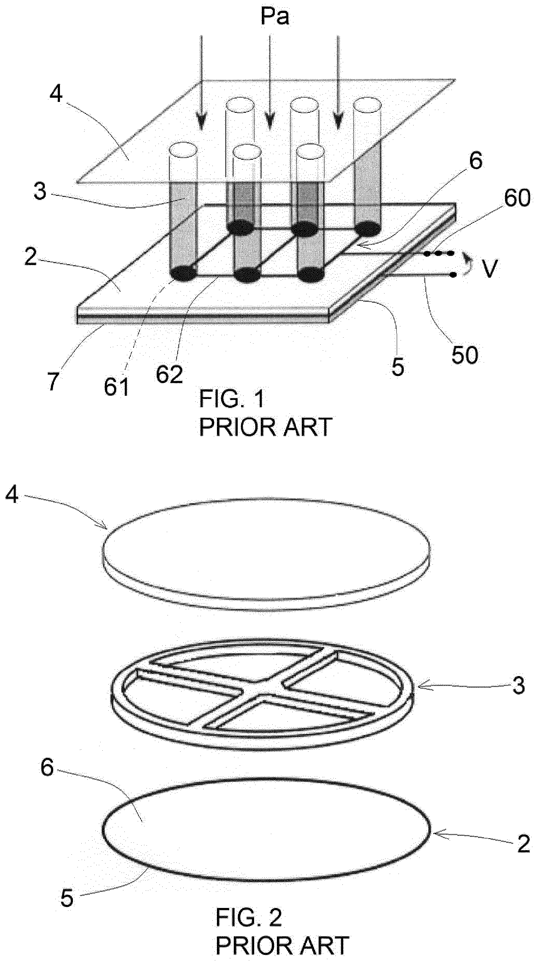

The present invention relates to a manufacturing method of a piezoelectric microphone with pillar structure. Figs. 1-4 illustrate examples which are not covered by the present invention.

Fig. 1 shows a piezoelectric microphone with pillar structure. A rigid dish (4) directly exposed to an acoustic pressure (Pa) transfers the incident force to a plurality of rigid pillars (3). The pillars (3) are in contact with a film (2) of piezoelectric material (PVDF, AIN, PLLA) and concentrate said incident force in a confined area of the film (2). The film (2) generates a polarization charge (Qp) on the stressed surface, proportional to the applied mechanical stress that is directly correlated with the acoustic pressure (Pa).

A first electrode (lower electrode) (5) and a second electrode (upper electrode) (6) are disposed on the surfaces of the piezoelectric film (2). The electrodes (5, 6) are connected to terminals (50, 60). In open circuit conditions, the voltage signal (V) at the ends of the terminals (50, 60) is related to the polarization charge (Qp) and to the equivalent capacity (C) of the system composed of the two electrodes (5, 6) and of the interposed film (2) according to the relation V = Qp/C.

The first electrode (5) is a plate. The second electrode (6) is a patterned electrode that comprises a plurality of conductive pads (61) in such a way to cover only the contact area between pillars (3) and film (2). Said conductive pads (61) are connected to each other and to the terminal (60) by means of a grid of conductive tracks (62). The purpose of the patterned shape of the second electrode (6) is to reduce the equivalent capacity (C) with respect to a configuration wherein both electrodes are composed of plates.

The microphone assembly is disposed on a substrate (7).

The net result of the two mechanisms (amplification of the mechanical stress and reduction of the electric capacity) allows for increasing the output voltage signal (V) and, consequently, the sensitivity of the microphone at the same acoustic pressure (Pa). The sensitivity increment is proportional to the ratio between the area of the rigid dish (4) and the sum of the sectional areas of the pillars (3).

J. Xu, L. M. Headings, and M. J. Dapino, "High Sensitivity Polyvinylidene Fluoride Microphone Based on Area Ratio Amplification and Minimal Capacitance," (IEEE Sens. J., vol. 15, no. 5, pages 2839-2847, 2015) discloses a piezoelectric microphone with pillar structure. The microphone uses a commercial piezoelectric film made of Polyvinylidene Fluoride (PVDF) as active element, with uniform electrodes that are already printed on both surfaces of the piezoelectric film. In the following description, the expression "active element" indicates the piezoelectric material that is responsible for the electromechanical transduction.

With reference to Fig. 2, the manufacturing method of the microphone comprises the following steps:
- provision of a piezoelectric film (2) with upper electrode (6) and lower electrode (5) printed on the two sides of the piezoelectric film;
- an aluminum element (3), which is shaped like a target, is glued with cyanocrylate adhesive (M-bond 200) on the upper electrode (6), acting as rigid pillar;
- acetone is used to remove the excessive parts of the upper electrode (6), thus obtaining a patterned shape of the upper electrode;
- a rigid dish (4) is glued on the aluminum element (3);
- electrical contacts are obtained with the upper electrode (6) and the lower electrode (5) by means of copper strips disposed on the piezoelectric film (2);
- the assembly is glued on a rigid substrate.

Such a microphone has a reduced sensitivity, mainly because of a low ratio between the area of the rigid dish (4) and the sectional area of the aluminum element (3) that acts as force centralizer. As a matter of fact, such a manufacturing technique is impaired by a limit caused by the gluing of the aluminum element (3) with cyanoacrylate adhesive that is not sufficiently accurate to guarantee a high area ratio and consequently a good sensitivity.

J. Xu, D. Gallego-perez, M. J. Dapino and D. Hansford, "Validation and Characterization of an Acoustic Sensor Based on PVDF Micropillars and patterned electrodes" (in Proc. of the ASME 2010 Conf. on Smart Materials, Adaptive Structures and Intelligent System, Philadelphia, Pennsylvania, USA, September 28 - October 1, 2010) discloses a piezoelectric microphone with pillar structure made of piezoelectric material with the double function of signal generators and force centralizer.

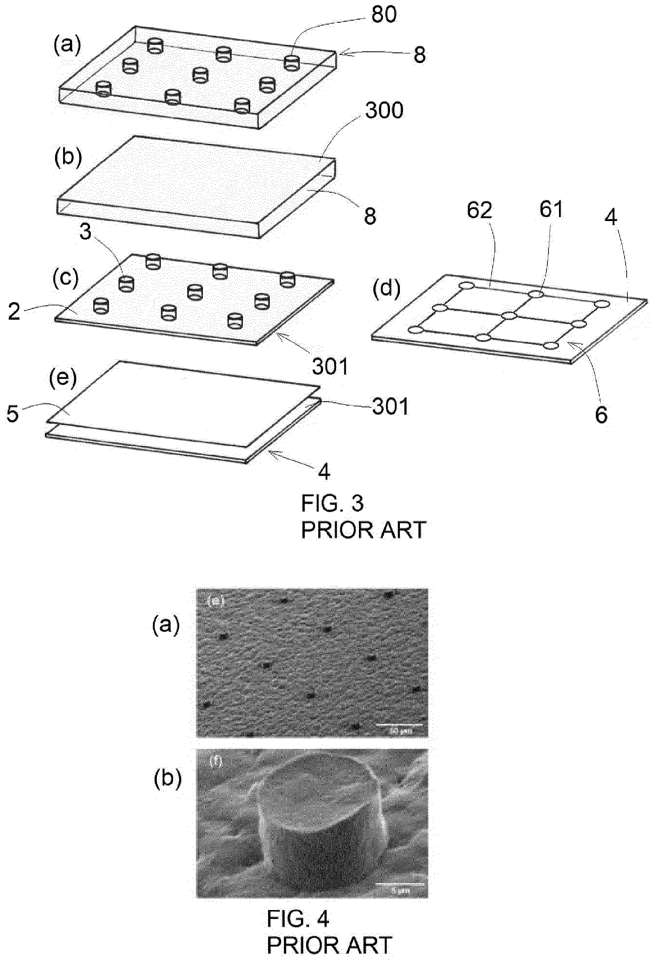

With reference to Fig. 3, the manufacturing method of the microphone comprises the following steps:
- provision of a mould (8) (Fig. 3a) made of polydimethylsiloxane (PDMS) with a plurality of blind holes (80) for the formation of the pillars;
- polyvinylidene fluoride (PVDF) in liquid solution (300) (Fig. 3B) is deposited on the mould (8), obtaining a patterned piezoelectric film (301) (Fig. 3c) that comprises a film (2) and the pillars (3) (Figs. 4a and 4b are views of portions of the patterned film (301) enlarged with the SEM);
- a patterned upper electrode (6) (Fig. 3d) is obtained on a rigid dish (4) composed of a glass substrate, with photolithographic technique, forming pads (61) and connection tracks (62);
- an optical alignment is performed to make the pillars (3) of the patterned film (301) coincide with the pads (61) of the patterned electrode (6);
- the film (2) of the patterned film (301) is fixed on the rigid dish (4) by means of hot-pressing;
- a lower electrode (5) composed of a copper plate (Fig. 3e) is applied on the pillars (3) of the patterned film;
- the PVDF of the patterned film (301) is polarized;
- the assembly is glued on a rigid substrate.

The general process is complicated and delicate, and some steps are especially critical, for example the optical alignment between the patterned film (301) and the patterned electrode (6), and the polarization of the piezoelectric material of the patterned film (301). Moreover, the open-circuit sensitivity of the microphone is not satisfactory.

The purpose of the present invention is to eliminate the drawbacks of the prior art by disclosing a manufacturing method of a piezoelectric microphone with pillar structure characterized by high sensitivity.

Another purpose of the present invention is to disclose such a manufacturing method of a microphone that is inexpensive and easy to manufacture.

These purposes are achieved according to the invention with the characteristics of the independent claims 1 and 10.

Advantageous embodiments of the invention appear from the dependent claims.

The manufacturing method of a piezoelectric microphone with pillar structure according to the invention is defined in the independent claims 1 and 10.

Additional features of the invention will appear clearer from the following detailed description, which refers to merely illustrative, not limiting embodiments, which are shown in the appended figures, wherein:
Fig. 1 is a diagrammatic perspective view of a pillar microphone according to the prior art;
Fig. 2 is an exploded diagrammatic perspective view of a second embodiment of a microphone according to the prior art;
Figs. 3a, 3b, 3c, 3d and 3e are diagrammatic views of a manufacturing method of a third embodiment of a microphone according to the prior art;
Figs. 4a and 4b are SEM views of the patterned film of Fig. 3c;
Fig. 5 is a diagrammatic perspective view of a first embodiment of a microphone with pillar structure according to the invention;
Fig. 6 is a diagrammatic perspective view of a second embodiment of a microphone with pillar structure according to the invention;
Fig. 7 is a diagrammatic sectional view of the microphone of Fig. 6;
Fig. 8 is a plan view of a pattern for the creation of a screen for the deposition, by means of screen-printing, of the patterned upper electrode of the microphone of Fig. 7;
Fig. 9 is a plan view of a rigid dish with patterned electrode and pillars of the microphone of Fig. 7;
Fig. 10 is an enlarged view of a portion of Fig. 9;
Fig. 11 is a block diagram that shows a measure setup for a microphone according to the invention and a reference microphone; and
Fig. 12 is a chart that shows the sensitivity as a function of the frequency measured in the microphone according to the invention.

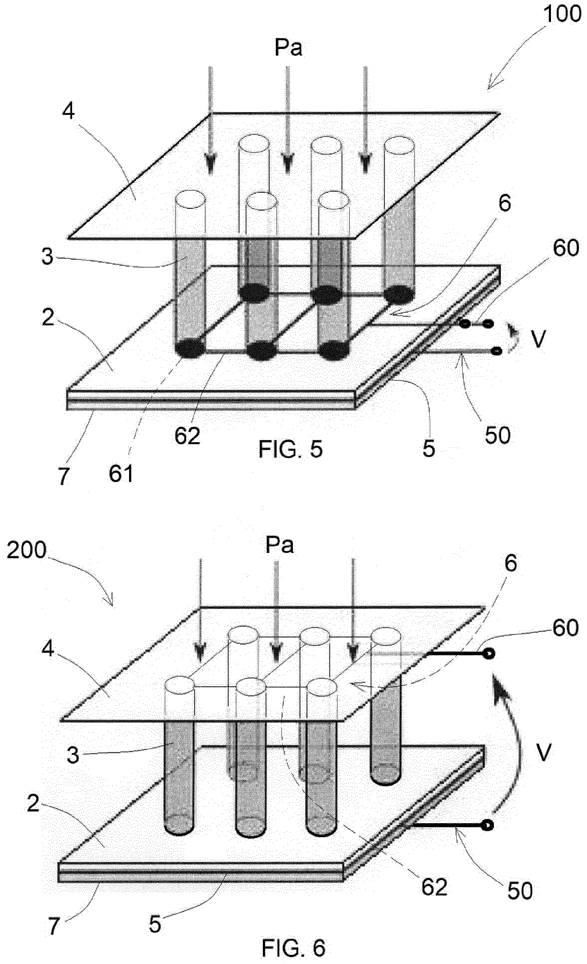

Fig. 5 shows a microphone (100) according to a first embodiment of the invention. Fig. 6 shows a microphone (200) according to a second embodiment of the invention.

Both embodiments comprise a rigid structure suitable for transferring a force (acoustic pressure (Pa)), which is incident on a rigid dish (4), on a confined area of a film (2) made of piezoelectric material. Such a rigid structure is composed of the rigid dish (4) and a plurality of pillars (3). The rigidity of the rigid dish (4) and of the pillars (3) is sufficient to guarantee an effective transfer of the force, avoiding undesired resonance phenomena. The number of pillars (3) is such to ensure the stability of the rigid structure, while maintaining a high area ratio (sensitivity).

In both embodiments, the piezoelectric film (2) produces the same quantity of polarization charge on the stressed surfaces, in correspondence of the base of the pillars (3).

In the microphone (100) of the first embodiment, a patterned electrode (6) is obtained on the upper surface of the piezoelectric film (2). The patterned shape of the patterned electrode (6) is composed of conductive pads (61) that cover only the contact area between the film (2) and the pillars (3), minimizing the equivalent capacity. The conductive tracks (62) that interconnect the pads (61) of the patterned electrode (6) have a minimum thickness, in such a way to reduce parasitic capacitative effects. In the microphone (100) of the first embodiment, a voltage signal (V) is picked up at the ends of the two terminals (50, 60) connected to an electrode (5) that is shaped like a plate and is disposed under the film (2) and to the patterned electrode (6) that is disposed above the film (2).

The microphone (200) of the second embodiment has pillars (3) of electrically conductive material, obtaining a patterned electrode (6) on a lower surface of the rigid dish (4). The delocalization of the patterned electrode (6), with the same patterned shape and without considering the parasitic effects, does not involve a variation of the equivalent capacity; therefore, the voltage signal (V) between the terminals (50, 60) of the two electrodes (5, 6) will be equal to the one obtained in the microphone (100) of the first embodiment.

The main characteristic of the invention is the manufacturing of the patterned electrode (6) and of the pillars (3) with substrate deposition technologies, such as screen-printing, dispenser-printing or spray-coating. These technologies permit an Additive Manufacturing of the patterned electrode (6) and of the pillars (3) by means of multiple aligned depositions of metallic material in solution. Each deposition is followed by an evaporation step of the solvent, obtaining a thin metallic layer that is characterized by a variable thickness on micrometric or nanometric scale. The expected thickness of each deposition depends on the technology used and on the process parameters. Multiple depositions will provide pillars with the desired height.

The use of metallic material in solution (for example, silver paste) makes it possible to manufacture the patterned electrode and the pillars in one work session, avoiding material waste. Moreover, a good mechanical rigidity and a good electrical conductivity of the pillars are guaranteed.

The pillars are formed by means of multiple depositions starting from the patterned electrode. The aforementioned technologies ensure high accuracy, and guarantee a high ratio between the area of the rigid dish (4) and the sectional area of the pillars (3) (which is a critical factor for the microphone sensitivity). Moreover, the manufacturing process is considerably easier than the solution with patterned piezoelectric film of the prior art.

The manufacturing process of the microphone (100) according to the first embodiment of the invention comprises the following steps:
- the lower electrode (5) is obtained on a lower side of the piezoelectric film (2), by means of a deposition or print technique of a conductive material;
- the patterned upper electrode (6) is obtained on an upper side of the piezoelectric film (2) by means of a first deposition or print of conductive material that forms the pads (61) of the patterned electrode;
- the pillars (3) are obtained on the pads (61) of the patterned electrode by means of successive depositions or prints of rigid material, in aligned position with the pads (61) of the patterned electrode (6).
- the rigid dish (4) is constrained to the pillars (3) and/or to the piezoelectric film (2) by means of a conductive glue, in such a way to obtain an assembly; and
- the assembly is glued on a rigid substrate (7).

The manufacturing process of the microphone (200) according to the second embodiment of the invention comprises the following steps:
- the lower electrode (5) is obtained on a lower side of the piezoelectric film (2) by means of a deposition or print technique of a conductive material;
- the patterned upper electrode (6) is obtained on a lower side of the rigid dish (4) by means of a first deposition or print of conductive material that forms the pads (61) of the patterned electrode;
- the pillars (3) are obtained on the pads (61) of the patterned electrode by means of successive depositions or prints of conductive material, in aligned position with the pads (61) of the patterned electrode (6);
- the piezoelectric film (4) is constrained to the pillars (3) and/or to the rigid dish (4) by means of a conductive glue, in such a way to obtain an assembly; and
- the assembly is glued on a rigid substrate (7).

The manufacturing of the pillars (3) from the patterned electrode (6) avoids the critical step for the optical alignment between the pillars and the patterned electrode.

The main advantages of the screen-printing technology (or of other printing technologies) compared to the traditional deposition technologies are:
- immediate scalability for mass production (commercial screen-printing machines can easily print on substrates with 500mm x 500mm dimensions).
- The traditional manufacturing technologies are of subtractive type (i.e. the material is deposited everywhere and then is removed), whereas the technology of the present invention is of additive type (i.e. the material is only deposited where it is necessary). Such an approach minimizes the waste of material.
- Microphones can be manufactured at low cost, with a high throughput, and with low input barriers (screen-printing machines can be purchased for a few tens of thousands of Euro and can print on large areas. The use of dispense printing is cost-effective and does not require the use of screens).
- The design can be easily scaled to obtain different shapes and dimensions. Furthermore, the use of conformal substrates permits to insert the microphone in previously designed objects, with high design flexibility.

A manufacturing process of the microphone (200) according to the second embodiment of the invention is described below.

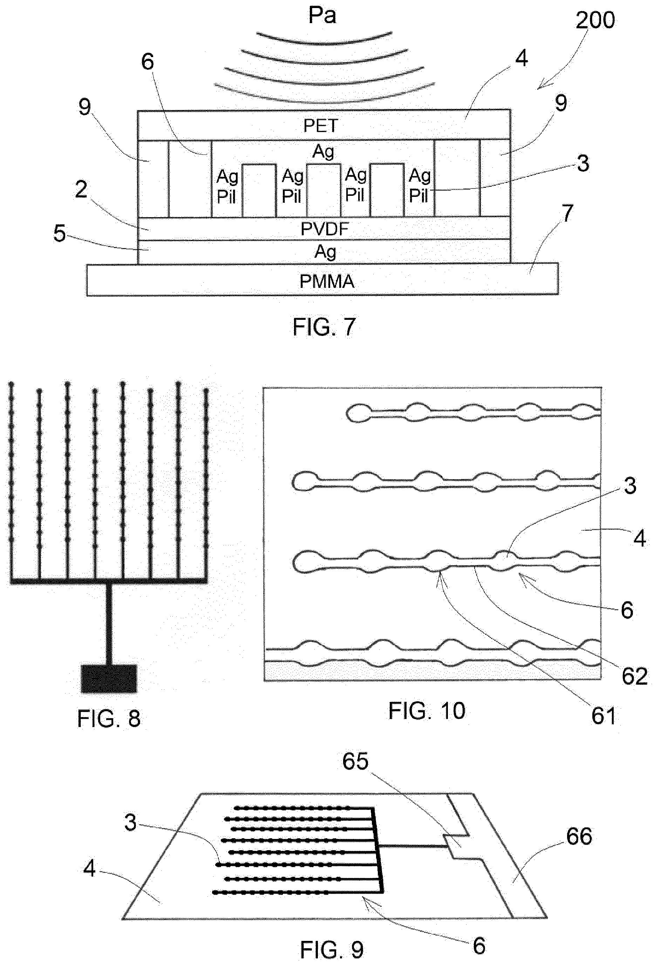

With reference to Fig. 7, a piezoelectric film (2) of Polyvinylidene Fluoride (PVDF), with thickness of 39 µm is used as active element. The piezoelectric film (2) is already polarized, without electrodes. The use of the PVDF is justified by its high sensitivity under voltage compared to ceramic materials. Moreover, the PVDF has a high resistance to contaminants and radiations and is heavy-metal free. However, other materials with the same piezoelectric properties, such as Aluminum Nitride (AIN) and Polylactic Acid (PLLA), can be used.

The rigid dish (4) is a PET plate with 100 µm thickness. The substrate (7) is made of PMMA.

The lower electrode (5) is deposited on a lower side of the piezoelectric film (2) of PVDF with screen-printing or dispenser-printing technology by means of deposition of a conductive material (for example silver). The lower electrode (5) is shaped like a plate with a thickness higher than 5 micrometers.

The patterned upper electrode (6) is obtained on the rigid dish (4) (made of PET, for example), with screen-printing or dispenser-printing technology, by means of a first deposition of conductive material. In case of screen-printing, during the design step, a screen is defined according to the geometry and arrangement of the elements to be printed. Fig. 8 shows a pattern used to prepare the screen needed for the deposition of silver to obtain the patterned upper electrode (6).

No screen is necessary in case of dispenser-printing because the elements are printed directly from a Gerber file.

With reference to Figs. 9 and 10, the patterned electrode (6) is composed of 96 pads (61) with circular shape and 1mm diameter (pillar base), spaced by 5 mm in the longitudinal direction and 10 mm in the transverse direction. The tracks (62) that connect the pads (61) have a width of 0.5 mm .

The rigid dish (4) (made of PET, for example) has an area A = 5 x 5 = 25 cm² exposed to the acoustic field. The sectional area of each pillar is S = 0.5² * π = 0.785 mm². The high number of 96 pillars (3) is necessary to guarantee the stability of the rigid dish (4) made of PET. Therefore, the total sectional area of all pillars is S_{T} = 75.36 mm². In view of the above, a ratio between the area of the rigid dish and the sectional area of all pillars equal to R= A/S = 33.17 is obtained. Such a ratio (R) is sufficiently high to guarantee an excellent sensitivity.

If at least 90 pillars with 1 mm diameter are obtained, which are oppositely spaced by 5 mm in longitudinal direction and 10 mm in transverse direction, a ratio (R) between the area of the rigid dish and the sectional area of all pillars higher than 30 is obtained.

The patterned electrode (6) has an external pad (65) with rectangular shape that is disposed outside the active area to make the acquisition of the voltage signal easier. The external pad (65) permit to obtain a weldable contact outside the active area, making the correct acquisition of the voltage signal easier, without interfering with the dynamics of the system.

The pillars (3) are obtained by means of successive depositions of a conductive material (silver, for example), in aligned position with the pads (61) of the patterned electrode. Several depositions are performed and each deposition produces a layer of 6-7 µm of silver, for a total thickness of approximately 48-56 µm, preferably 55 µm for each pillar. A thermal annealing process must be performed between two consecutive deposited layers in order to make the pillar solid and conductive.

After the annealing process, the screen (in case of screen-printing) or the nozzles (in case of dispenser printing) must be accurately repositioned. The depositions that are performed to obtain the pillars are aligned by means of cameras and high-precision micromanipulators, with a maximum misalignment tolerance of 10% (0.05 mm). This characteristic is fundamental in order to obtain pillars with a high shape factor. Experimental tests confirmed that the thickness of 55 µm of the pillar (3) is a limitation for the realization of high-quality uniform pillars.

A thin copper strip (66) is added in the proximity of the silver external pad (65) in order to make a welding that is necessary to pick up the signal. The electrical connection between the copper strip (66) and the rectangular pad (65) is guaranteed by silver paste disposed on the rectangular pad (65) that acts as bridge.

The piezoelectric film (2) made of PVDF is glued to the substrate (7) made of PMMA with cyanoacrylate adhesive.

A thin copper strip is disposed between the piezoelectric film (2) made of PVDF and the substrate (7) and is connected to the lower electrode (5). The electrical connection between the copper strip and the lower electrode (5) is guaranteed by silver paste disposed on the lower electrode that acts as bridge.

The rigid dish (4) made of PET is glued on the two edges of the piezoelectric film (2) made of PVDF with cyanoacrylate adhesive (9) (Fig. 7). The adhesion is performed at a suitable distance from the active area. Alternatively, the rigid dish (4) made of PET can be directly constrained to the pillars (3) without being anchored to the edges with cyanoacrylate adhesive.

The sensitivity of the microphone (200) was measured in free field simulated in anechoic chamber by means of an Exponential Sinusoidal Sweep (ESS) technology. A secondary characterization method according to the IEC 61094-8 standard is used to make a comparison with free-field calibrated Bruel & Kjaer laboratory microphone of type 4189.

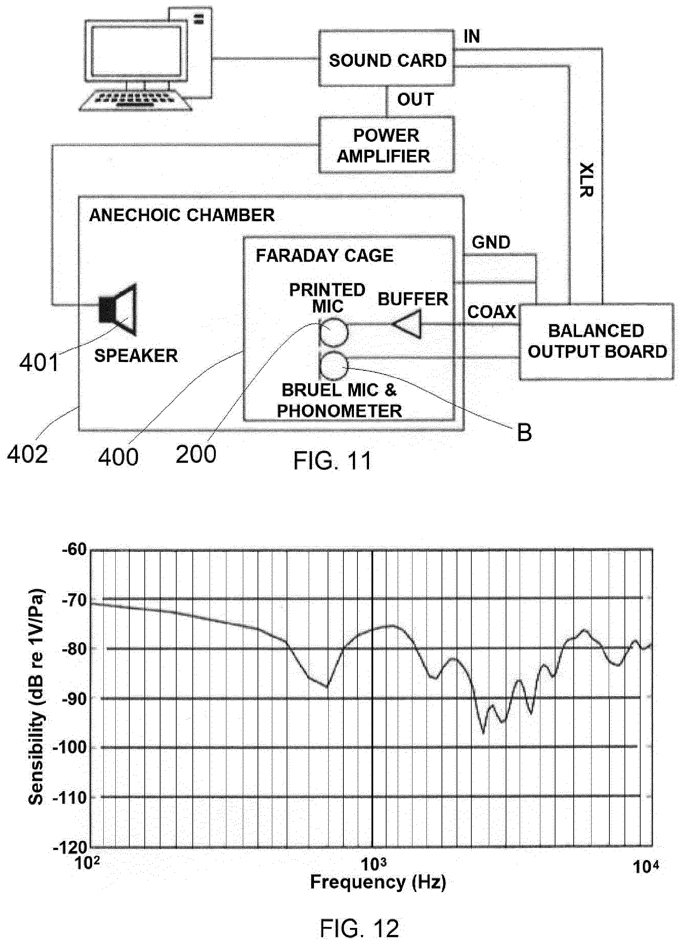

Fig. 11 shows a measure setup for the microphone (200) according to the invention and for a reference microphone (B). The microphone (200) of the invention and the reference microphone (B) are disposed at a distance of 1 m to ensure far-field conditions. Both microphones are contained in a Faraday cage (400) to minimize the electromagnetic interference. The output voltage of the microphone (200) is conditioned by a voltage buffer, which is characterized by a high input impedance (10 MΩ), in such a way to ensure a cut-off frequency outside the audio band.

A dynamic speaker (401) and the Faraday cage (400) are disposed in an anechoic chamber (402). The dynamic speaker (401) generates a pressure signal of ESS type.

The reference microphone (B) is used to measure the actual incident sound pressure, which is necessary to determine the sensitivity of the microphone (200) according to the invention. The measured sensitivity was normalized at a standard pressure of 94 dB SPL.

Fig. 12 shows the sensitivity of the microphone (200) according to the invention as a function of the frequency. As shown in Fig. 12, the sensitivity is approximately constant around 100 µV/Pa (-80 dB V/Pa). Therefore the sensitivity values of the microphone (200) according to the invention are considerably better than the sensitivity values of the traditional microphones, which approximately range from 1 mV/Pa (dynamic) to 50 mV/Pa (capacitor)).
Numerous equivalent variations and modifications, which are within the reach of an expert of the field and fall in any case within the scope of the invention as disclosed by the appended claims, can be made to the present embodiments of the invention.

## Claims

1. Manufacturing method of a microphone (100), wherein the microphone (100) comprises:
- a piezoelectric film (2) of piezoelectric material,
- a lower electrode (5) disposed on a lower side of the piezoelectric film (2),
- a patterned upper electrode (6) comprising pads (61) disposed on an upper side of the piezoelectric film,
- pillars (3) disposed on the pads (61) of the patterned electrode,
- a rigid dish (4) disposed on said pillars;
said method comprising the following steps:
- making of the patterned upper electrode (6) by means of a first deposition of conductive material on an upper side of the piezoelectric film (2) in such a way to form the pads (61) of the patterned electrode,
and **characterised by**
- making of the pillars (3) by means of successive depositions of rigid material, in aligned position on the pads (61) of the patterned electrode,
wherein said first deposition and said successive depositions are made by means of screen-printing, dispenser-printing or spray-coating of material in liquid or semifluid state.

2. The method of claim 1, wherein said lower electrode (5) is obtained by means of a deposition of conductive material on the lower side of the piezoelectric film (2), by means of screen-printing, dispenser-printing or spray-coating of material in liquid or semifluid state.

3. The method of any one of the preceding claims, wherein the rigid material of the pillars (3) is the same conductive material as the one of the patterned upper electrode (6).

4. The method of claim 3, wherein the rigid material of the pillars (3) and the conductive material of the patterned upper electrode (6) are silver paste.

5. The method of any one of the preceding claims, wherein said pillars (3) are obtained by means of a plurality of successive depositions, performing a thermal annealing process between a deposited layer and the successive deposited layer.

6. The method of claim 5, wherein each pillar has a thickness of 48-56 µm that is obtained with 8 successive depositions.

7. The method of any one of the preceding claims, wherein at least 90 pillars with 1 mm diameter are obtained, oppositely spaced in such a way to obtain a ratio between the area of the rigid dish (4) exposed to the acoustic field and the sectional area of all pillars (3) higher than 30.

8. The method of any one of the preceding claims, wherein said piezoelectric film (2) is made of polyvinylidene fluoride (PVDF) or aluminum nitride (AIN) and polylactic acid (PLLA).

9. The method of any one of the preceding claims, wherein said rigid dish (4) is made of polyethylene terephthalate (PET).

10. A manufacturing method of a microphone (200), wherein the microphone (200) comprises:
- a piezoelectric film (2) of piezoelectric material,
- a lower electrode (5) disposed on a lower side of the piezoelectric film (2),
- a rigid dish (4),
- a patterned upper electrode (6) comprising pads (61) disposed on a lower side of the rigid dish (4),
- pillars (3) disposed on the pads (61) of the patterned electrode and on the piezoelectric film (2),
said method comprising the following steps:
- making of the patterned upper electrode (6) by means of a first deposition of conductive material on a lower side of the rigid dish (4) in such a way to form the pads (61) of the patterned electrode, and **characterised by**
- making of the pillars (3) by means of successive depositions of rigid conductive material, in aligned position on the pads (61) of the patterned electrode,
wherein said first deposition and said successive depositions are made by means of screen-printing, dispenser-printing or spray-coating of material in liquid or semifluid state.

11. The method of claim 10, wherein said lower electrode (5) is obtained by means of a deposition of conductive material on the lower side of the piezoelectric film (2), by means of screen-printing, dispenser-printing or spray-coating of material in liquid or semifluid state.

12. The method of claim 10 or 11, wherein the rigid material of the pillars (3) is the same conductive material as the one of the patterned upper electrode (6).

13. The method of claim 12, wherein the rigid material of the pillars (3) and the conductive material of the patterned upper electrode (6) are silver paste.

14. The method of any one of the claims 10 to 13, wherein said pillars (3) are obtained by means of a plurality of successive depositions, performing a thermal annealing process between a deposited layer and the successive deposited layer.

15. The method of claim 14, wherein each pillar has a thickness of 48-56 µm that is obtained with 8 successive depositions.

## Patentansprüche

1. Verfahren zur Herstellung eines Mikrofons (100), wobei das Mikrofon (100) umfasst:
- einen piezoelektrischen Film (2) aus piezoelektrischem Material,
- eine untere Elektrode (5), die auf einer unteren Seite des piezoelektrischen Films (2) angeordnet ist,
- eine obere geformte (patterned) Elektrode (6), umfassend Pads (61), die auf einer oberen Seite des piezoelektrischen Films angeordnet sind,
- Säulen (pillars) (3), die auf den Pads (61) der geformten Elektrode angeordnet sind,
- eine starre Scheibe (4), die auf den Säulen angeordnet ist;
wobei das Verfahren die folgenden Schritte umfasst:
- Herstellung der oberen geformten Elektrode (6) mittels einer ersten Abscheidung von leitfähigem Material auf einer oberen Seite des piezoelektrischen Films (2), so dass die Pads (61) der geformten Elektrode gebildet werden,
**gekennzeichnet durch**
- Herstellung der Säulen (3) mittels darauffolgender Abscheidungen von starrem Material in einer ausgerichteten Position auf den Pads (61) der geformten Elektrode,
wobei die erste Abscheidung und die darauffolgenden Abscheidungen mittels Screen-Druck, Dispenser-Druck oder Spray Coating von Material in flüssigem oder halbflüssigem Zustand vorgenommen werden.

2. Verfahren nach Anspruch 1, wobei die untere Elektrode (5) mittels Abscheidung von leitfähigem Material auf der unteren Seite des piezoelektrischen Films (2) mittels Screen-Druck, Dispenser-Druck oder Spray Coating von Material in flüssigem oder halbflüssigem Zustand erhalten wird.

3. Verfahren nach einem der vorstehenden Ansprüche, wobei das starre Material der Säulen (3) dasselbe leitfähige Material wie das der oberen geformten Elektrode (6) ist.

4. Verfahren nach Anspruch 3, wobei das starre Material der Säulen (3) und das leitfähige Material der oberen geformten Elektrode (6) Silberpaste ist.

5. Verfahren nach einem der vorstehenden Ansprüche, wobei die Säulen (3) mittels einer Mehrzahl von aufeinander folgenden Abscheidungen hergestellt werden, wobei ein Wärmebehandlungsschritt zwischen einer Abscheidungsschicht und der darauffolgenden Abscheidungsschicht vorgenommen wird.

6. Verfahren nach Anspruch 5, wobei jede Säule eine Dicke von 48 - 56 um aufweist, die mit 8 aufeinander folgenden Abscheidungen erhalten wird.

7. Verfahren nach einem der vorstehenden Ansprüche, wobei mindestens 90 Säulen mit einem Durchmesser von 1 mm hergestellt werden, die gegenüberliegend beabstandet sind, so dass ein Verhältnis zwischen der dem Schallfeld ausgesetzten Oberfläche der starren Scheibe (4) und der Querschnittsfläche aller Säulen (3) größer als 30 ist.

8. Verfahren nach einem der vorstehenden Ansprüche, wobei der piezoelektrische Film (2) aus Polyvinylidendifluorid (PVDF) oder Aluminiumnitrid (AIN) und Polymilchsäure (PLLA) besteht.

9. Verfahren nach einem der vorstehenden Ansprüche, wobei die starre Scheibe (4) aus Polyethylentherephthalat (PET) besteht.

10. Verfahren zur Herstellung eines Mikrofons (200), wobei das Mikrofon (200) umfasst:
- einen piezoelektrischen Film (2) aus piezoelektrischem Material,
- eine untere Elektrode (5), die auf einer unteren Seite des piezoelektrischen Films (2) angeordnet ist,
- eine starre Scheibe (4),
- eine obere geformte (patterned) Elektrode (6), umfassend Pads (61), die auf einer unter Seite der starren Scheibe (4) angeordnet sind,
- Säulen (pillars) (3), die auf den Pads (61) der geformten Elektrode und auf dem piezoelektrischen Film (2) angeordnet sind,
wobei das Verfahren die folgenden Schritte umfasst:
- Herstellung der oberen geformten Elektrode (6) mittels einer ersten Abscheidung von leitfähigem Material auf einer unter Seite der starren Scheibe (4), so dass die Pads (61) der geformten Elektrode gebildet werden,
und **gekennzeichnet ist durch**
- Herstellung der Säulen (3) mittels darauffolgender Abscheidungen von leitfähigem starrem Material in einer ausgerichteten Position auf den Pads (61) der geformten Elektrode,
wobei die erste Abscheidung und die darauffolgenden Abscheidungen mittels Screen-Druck, Dispenser-Druck oder Spray Coating von Material in flüssigem oder halbflüssigem Zustand vorgenommen werden.

11. Verfahren nach Anspruch 10, wobei die untere Elektrode (5) mittels Abscheidung von leitfähigem Material auf der unteren Seite des piezoelektrischen Films (2) mittels Screen-Druck, Dispenser-Druck oder Spray Coating von Material in flüssigem oder halbflüssigem Zustand erhalten wird.

12. Verfahren nach Anspruch 10 oder 11, wobei das starre Material der Säulen (3) dasselbe leitfähige Material wie das der oberen geformten Elektrode (6) ist.

13. Verfahren nach Anspruch 12, wobei das starre Material der Säulen (3) und das leitfähige Material der oberen geformten Elektrode (6) Silberpaste ist.

14. Verfahren nach einem der Ansprüche 10 bis 13, wobei die Säulen (3) mittels einer Mehrzahl von aufeinander folgenden Abscheidungen hergestellt werden, wobei ein Wärmebehandlungsschritt zwischen einer Abscheidungsschicht und der darauffolgenden Abscheidungsschicht vorgenommen wird.

15. Verfahren nach Anspruch 14, wobei jede Säule eine Dicke von 48 - 56 um aufweist, die mit 8 aufeinander folgenden Abscheidungen erhalten wird.

## Revendications

1. Méthode de réalisation d'un microphone (100), où le microphone (100) comprend :
- un film piézoélectrique (2) en matériau piézoélectrique,
- une électrode inférieure (5) disposée sur une face inférieure du film piézoélectrique (2),
- une électrode supérieure façonnée (patterned) (6) comprenant des tablettes (61) disposées sur une face supérieure du film piézoélectrique,
- des montants (pillar) (3) disposés sur les tablettes (61) de l'électrode façonnée,
- un petit plat rigide (4) disposé sur lesdits montants ;
ladite méthode comprenant les phases suivantes :
- réalisation de l'électrode supérieure façonnée (6) moyennant un premier dépôt sur une face supérieure du film piézoélectrique (2) d'un matériau conducteur de façon à former les tablettes (61) de l'électrode façonnée,
**caractérisée en ce que**
- réalisation des montants (3) moyennant des dépôts successifs de matériau rigide, alignés sur les tablettes (61) de l'électrode façonnée,
où ledit premier dépôt et lesdits dépôts successifs sont réalisés moyennant impression par sérigraphie (screen-printing), distributeur d'impression (dispenser-printing) ou revêtement par jet (spray-coating) de matériau à l'état liquide ou semi-fluide.

2. Méthode selon la revendication 1, où ladite électrode inférieure (5) est obtenue moyennant le dépôt de matériau conducteur sur la face inférieure du film piézoélectrique (2), moyennant impression par sérigraphie (screen-printing), distributeur d'impression (dispenser-printing) ou revêtement par jet (spray-coating) de matériau à l'état liquide ou semi-fluide.

3. Méthode selon l'une quelconque des revendications précédentes, où le matériau rigide des montants (3) est le même matériau conducteur de l'électrode supérieure façonnée (6).

4. Méthode selon la revendication 3, où le matériau rigide des montants (3) et le matériau conducteur de l'électrode supérieure façonnée (6) sont une pâte d'argent.

5. Méthode selon l'une quelconque des revendications précédentes, où lesdits montants (3) sont réalisés moyennant une pluralité de dépôts successifs, en effectuant un processus de recuit thermique entre une couche déposée et la couche successive déposée.

6. Méthode selon la revendication 5, où chaque montant a une épaisseur de 48-56 µm, obtenue par 8 dépôts successifs.

7. Méthode selon l'une quelconque des revendications précédentes, où au moins 90 montants de 1 mm de diamètre sont obtenus, espacés à l'opposé entre eux de façon à obtenir un rapport entre la surface du petit plat rigide (4) exposée au champ acoustique et la surface de la section de tous les montants (3) supérieure à 30.

8. Méthode selon l'une quelconque des revendications précédentes, où ledit film piézoélectrique (2) est en polyfluorure de vinylydène (PVDF) ou en nitrure d'aluminium (AIN) et acide polylactique (PLLA).

9. Méthode selon l'une quelconque des revendications précédentes, où ledit petit plat rigide (4) est en polyéthylène téréphtalate (PET).

10. Méthode de réalisation d'un microphone (200), où le microphone (200) comprend :
- un film piézoélectrique (2) en matériau piézoélectrique,
- une électrode inférieure (5) disposée sur une face inférieure du film piézoélectrique (2),
- un petit plat rigide (4),
- une électrode supérieure façonnée (patterned) (6) comprenant des tablettes (61) disposées sur une face inférieure du petit plat rigide (4),
- des montants (pillar) (3) disposés sur les tablettes (61) de l'électrode façonnée et sur le film piézoélectrique (2),
ladite méthode comprenant les phases suivantes :
- réalisation de l'électrode supérieure façonnée (6) moyennant un premier dépôt sur une face inférieure du petit plat rigide (4) d'un matériau conducteur de façon à former les tablettes (61) de l'électrode façonnée,
et **caractérisée par**
- la réalisation des montants (3) moyennant des dépôts successifs de matériau rigide, alignés sur les tablettes (61) de l'électrode façonnée,
où ledit premier dépôt et lesdits dépôts successifs sont réalisés moyennant impression par sérigraphie (screen-printing), distributeur d'impression (dispenser-printing) ou revêtement par jet (spray-coating) de matériau à l'état liquide ou semi-fluide.

11. Méthode selon la revendication 10, où ladite électrode inférieure (5) est obtenue moyennant le dépôt de matériau conducteur sur la face inférieure du film piézoélectrique (2), moyennant impression par sérigraphie (screen-printing), distributeur d'impression (dispenser-printing) ou revêtement par jet (spray-coating) de matériau à l'état liquide ou semi-fluide.

12. Méthode selon la revendication 10 ou 11, où le matériau rigide des montants (3) est le même matériau conducteur de l'électrode supérieure façonnée (6).

13. Méthode selon la revendication 12, où le matériau rigide des montants (3) et le matériau conducteur de l'électrode supérieure façonnée (6) sont une pâte d'argent.

14. Méthode selon l'une quelconque des revendications de 10 à 13, où lesdits montants (3) sont réalisés moyennant une pluralité de dépôts successifs, en effectuant un processus de recuit thermique entre une couche déposée et la couche successive déposée.

15. Méthode selon la revendication 14, où chaque montant a une épaisseur de 48-56 µm, obtenue par 8 dépôts successifs.
